# EUROPEAN PATENT SPECIFICATION

(11) **EP 1 981 087 B1**
(45) Date of publication and mention of the grant of the patent: **21.11.2012**
(21) Application number: 08160622.0
(22) Date of filing: 11.09.1997
(51) Int. Cl.: H01L 29/94, H03B 5/12, H03L 7/099

(54) **Electrical device comprising a voltage dependant capacitance and method for manufacturing the same**
Elektrische Anordnung mit einer spannungsabhängiger Kapazität und Verfahren zur Herstellung
Dispositif électrique comprenant une capacité variable avec la tension et procédé de fabrication

(43) Date of publication of application: 15.10.2008
(62) Divisional of application: 97850130.2
(73) Proprietor: Telefonaktiebolaget LM Ericsson (publ), 164 83 Stockholm (SE)
(72) Inventor: Mattisson, Sven, SE-237 36, BJÄRRED (SE); Litwin, Andrej, SE-182 35, DANDERYD (SE)
(74) Representative: Åkerman, Mårten Lennart

(56) References cited:
- JP-A- 6 132 728
- US-A- 5 045 966

## Description

### TECHNICAL FIELD OF INVENTION

The present invention relates to varactors and, in particular, to varactors suitable for integration. This kind of varactors are found, for example, in Voltage Controlled Oscillators and Phase Locked Loop circuits which, in their turn, are often used in radio communication devices. The present invention also relates to the manufacturing of such devices.

### DESCRIPTION OF RELATED ART

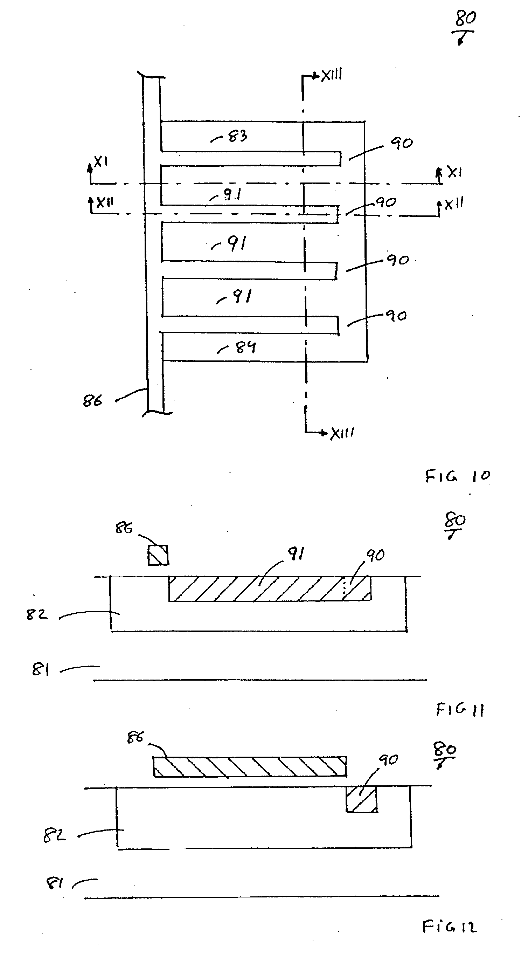

A varactor is an electrical device having a capacitance which is controlled by a suitable voltage or current bias. A varactor is used, for example, in Voltage Controlled Oscillators, VCO:s, where a frequency of an oscillator is controlled by an applied voltage or current bias. VCO:s are used, for example, when a variable frequency is required or when a signal needs to be synchronised to a reference signal. In radio communication devices, e.g. portable/cellular phones, VCO:s are often used in Phase Locked Loop, PLL, circuits to generate suitable signals. Generation of a reference signal which is synchronised with a signal received by a radio receiver, modulation/demodulation operations and frequency synthesis are examples of such uses. Several varactors suitable for Integrated Circuit, IC, technologies are known in the prior art. R. A. Molin and G. F. Foxhall discuss in "Ion-Implanted Hyperabrupt Junction voltage Variable Capacitors", IEEE Trans. Electron Devices, ED-19, pp. 267f, 1972, the use of pn-diodes as varactors which may be used in bipolar, CMOS or BiCMOS technologies. It is also known to use Schottky diodes or MOS-diodes as varactors. The latter is described, for example, by S. M. Sze in "Physics of Semiconductor Devices'' John Wiley & Sons, 2nd Edition, pp. 368f. The integration of the known varactors depends on the capability of the IC technology. An overview of the integrated devices for high frequency RF application in a BiCMOS process is given by J. N. Burghartz, M. Soyuer and K. Jenkins in "Integrated RF and Microwave Components in BiCMOS Technology'', IEEE Trans. Electron Devices, Vol. 43, pp. 1559-1570, Sept. 1996. As is stated on page 1568 and in figure 12 the varactors are not a part of the standard BiCMOS device set. Instead it is proposed to use a collector-base junction of a bipolar transistor as a varactor. J. Craninckx and M. S. J. Steyaert suggests in "A 1.8-GHz Low-Phase-Noise CMOS VCO Using Optimized Hollow Spiral Inductors" , IEEE J. Solid-State Circuits, Vol. 32, pp. 736-744, May 1997, the use of a p+/n-well junction diode as a varactor in a VCO which is integrated by means of a CMOS process.

Whilst the known form of varactors described above functions quite adequately, they do have a number of disadvantages.

One drawback of the known varactors is that they are difficult to realise with high quality factors, Q, especially for high frequency applications in a conventional CMOS process due to their high series resistance or required additional manufacturing steps. This results in low yield and high manufacturing costs.

Another drawback of the known pn-junction varactors is that in many applications, such as when used in most VCO circuits, a DC de-coupling capacitor needs to be added to the design which makes the design even more difficult to integrate into an IC. The use of a DC de-coupling capacitor externally to the IC adds on to the overall cost of the implementation and consumes valuable space on a Printed Circuit Board, PCB. These drawbacks becomes even more pronounced in hand-held devices, such as portable phones, which need to be small and which are produced in high-volumes.

US 5,045,966 discloses a method of forming a stable capacitance. The document describes a capacitance wherein the length of the upper capacitor plate is made short enough so that dopants, which are implanted into exposed regions of the substrate on both sides of the plate, will side-diffuse under the plate and substantially merge under the plate. This is achieved by a less than permissible source/drain separation for an operable MOS transistor.

JP 06132728 discloses an approach to narrow the variable range of an oscillation frequency in accordance with a purpose of a VCO and to reduce jitter even when a control voltage changes in a wide range from ground voltage to power voltage in a voltage control type oscillation circuit realized in an MOS type integrated circuit. MOS capacitors are formed on an N-type semiconductor substrate by using a conventional two terminal-type LC oscillation circuit with low jitter. The circuit is composed by connecting an inverter circuit formed on the N-type semiconductor substrate with externally added capacitors and a coil. A gate electrode of one MOS capacitor is connected to the input of the inverter circuit, and the gate electrode of another MOS capacitor is connected to the output of the inverter circuit. Well electrodes of the MOS capacitors are connected to a control voltage impression terminal and the potential of well layers in the MOS capacitors is controlled and set by the control voltage.

It is an object of the present invention to provide a varactor which overcomes or alleviates the above mentioned problems.

### SUMMARY OF THE INVENTION

The above mentioned problems are overcome or alleviated by providing method of manufacturing an electrical device having a voltage dependent capacitance according to the independent claim. Embodiments are provided according to the dependent claim.

The problems of the prior art are overcome by providing a electrical device having a voltage dependent capacitance which may be implemented by the use of a conventional CMOS process. Furthermore, since the insulating layer (in the case of a MOS transistor: an oxide layer) separates the substantially conductive element connected to the first electrode (in the case of a MOS transistor: the gate) from the second and third regions connected to the second electrode (in the case of a MOS transistor: the drain/source) the device may be used, for example in a VCO circuit, without the need for a DC de-coupling capacitor.

Examples are a VCO, a PLL and a radio communication device making use of a varactor as discussed above. Thus, a method of manufacturing a varactor according to the present invention is provided.

An advantage of the present invention is that a varactor having a high quality factor, Q, *i*.*e*. with low series resistance, may be realised even for high frequency applications by using a conventional CMOS process without adding any manufacturing steps. The varactors may therefore be manufactured at high yield and to low costs.

Furthermore, an advantage of the present invention is that a VCO is provided which may be realised by using a conventional CMOS process and which does not need a DC de-coupling capacitor in the design. This makes the implementation of the VCO inexpensive and physically small since no DC de-coupling capacitor is needed neither on the IC nor externally to the IC on a PCB. These advantages becomes even more pronounced when implemented in hand-held devices, such as portable phones, which need to be small and which are produced in high-volumes.

Advantageously, the methods can provide an integrated Voltage Controlled Oscillator and/or Phase Locked Loop, PLL, circuit, which include a varactor as discussed above, by using a conventional CMOS process.

Since many of the functions of a radio communication device may be integrated by conventional CMOS processes, the integration of a VCO and/or a PLL circuits together with these functions allows the present invention to provide a radio communication device with a high degree of integration and thus small physical dimensions. The high degree of integration also reduces the manufacturing costs.

### BRIEF DESCRIPTION OF THE DRAWINGS

FIG 1 illustrates a varactor according to a first example comprising a PMOS enhancement transistor;
FIG 2 illustrates a varactor according to a second example comprising a NMOS enhancement transistor;
FIG 3 illustrates a varactor according to a third example comprising a NMOS depletion transistor;
FIG 4 illustrates an operational aspect of the first example;
FIG 5 illustrates an equivalent circuit diagram of the first example;
FIG 6 illustrates a circuit diagram of a Voltage Controlled Oscillator according to a fourth example;
FIG 7 illustrates a top-view of a composite varactor according to a fifth example;
FIG 8 illustrates a cross-section view along the axis VIII-VIII of FIG 7;
FIG 9 illustrates a cross-section view along the axis IX-IX of FIG 7;
FIG 10 illustrates a top-view of a composite varactor according to the present invention;
FIG 11 illustrates a cross-section view along the axis XI-XI of FIG 10;
FIG 12 illustrates a cross-section view along the axis XII-XII of FIG 10;
FIG 13 illustrates a cross-section view along the axis XIII-XIII of FIG 10.

### DETAILED DESCRIPTION OF EMBODIMENTS

Embodiments of the present invention are described below, by way of example only. It should be noted that details illustrated in the figures may not be drawn to scale. On the contrary, the dimensions of the details of the illustrations are chosen so as to improve the understanding of the present invention.

According to the present invention there is provided an electrical device having a voltage dependent capacitance. Such a device is also called a varactor. It will be appreciated that the varactor of the present invention may easily be integrated in a conventional CMOS process.

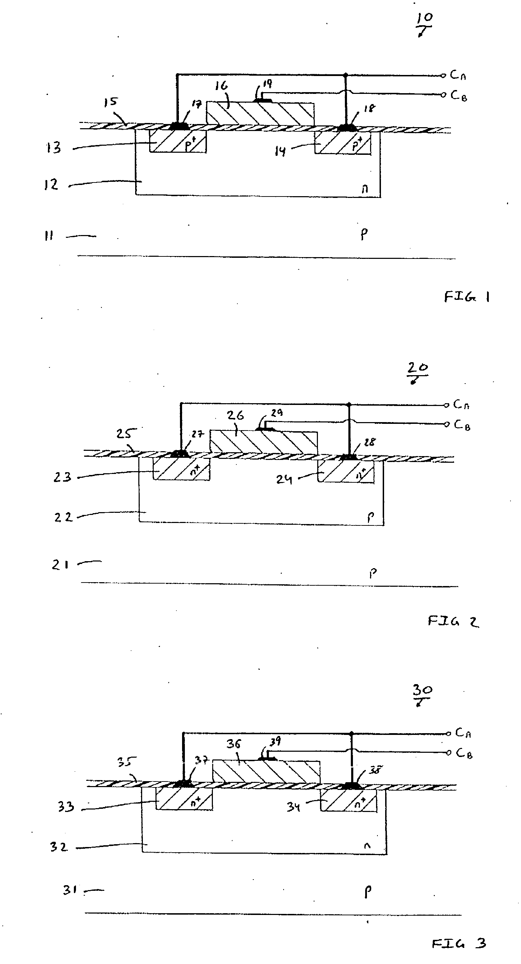

FIG 1 illustrates a varactor 10 according to a first example comprising a PMOS enhancement transistor. The transistor is formed in a p-type silicon substrate 11. An n-type well 12 is formed in the p-type silicon substrate 11 from a first principal surface of the substrate and a p⁺-type source region 13 and a p⁺-type drain region 14 are formed in the n-type well 12. The impurity concentration of the source and drain regions 13, 14 is chosen to be greater than the impurity concentration of the well region 12. Thereafter an insulating layer 15, preferably of silicon oxide, is formed on the first principal surface of the substrate and a poly-silicon gate 16 is formed on the insulating layer 15 at least covering a part of the n-well region 12 separating the source region 13 and the drain region 14 and such that the gate 16 is electrically insulated from the n-well region 12. A common electrode C_{A} of the varactor 10 is formed by connecting the source region 13 to the drain region 14. Connection is made to the source region 13 and the drain region 14 by means of a source electrode 17 and a drain electrode 18, respectively. A second electrode C_{B} of the varactor 10 is connected to the gate 16 by means of a gate electrode 19.

FIG 2 illustrates a varactor 20 according to a second example comprising a NMOS enhancement transistor. The transistor is formed in a p-type silicon substrate 21. A p-type well 22 is formed in the p-type silicon substrate 21 from a first principal surface of the substrate and an n⁺-type source region 23 and an n'-type drain region 24 are formed in the p-type well 22. The impurity concentration of the source and drain regions 23, 24 is chosen to be greater than the impurity concentration of the well region 22. Thereafter an insulating layer 25, preferably of silicon oxide, is formed on the first principal surface of the substrate and a poly-silicon gate 26 is formed on the insulating layer 25 at least covering a part of the p-well region 22 separating the source region 23 and the drain region 24 and such that the gate 26 is electrically insulated from the p-well region 22. A common electrode C_{A} of the varactor 20 is formed by connecting the source region 23 to the drain region 24. Connection is made to the source region 23 and the drain region 24 by means of a source electrode 27 and a drain electrode 28, respectively. A second electrode C_{B} of the varactor 20 is connected to the gate 26 by means of a gate electrode 29.

FIG 3 illustrates a varactor 30 according to a third example comprising a NMOS depletion transistor. The transistor is formed in a p-type silicon substrate 31. An n-type well 32 is formed in the p-type silicon substrate 31 from a first principal surface of the substrate and an n⁺-type source region 33 and an n'-type drain region 34 are formed in the p-type well 32. The impurity concentration of the source and drain regions 33, 34 is chosen to be greater than the impurity concentration of the well region 32. Thereafter an insulating layer 35, preferably of silicon oxide, is formed on the first principal surface of the substrate and a poly-silicon gate 36 is formed on the insulating layer 35 at least covering a part of the n-well region 32 separating the source region 33 and the drain region 34 and such that the gate 26 is electrically insulated from the n-well region 32. A common electrode C_{A} of the varactor 30 is formed by connecting the source region 33 to the drain region 34. Connection is made to the source region 33 and the drain region 34 by means of a source electrode 37 and a drain electrode 38, respectively. A second electrode C_{B} of the varactor 30 is connected to the gate 36 by means of a gate electrode 39.

More generally the varactor can be defined as having a first region 12, 22, 32 of a semiconductor material in which a second region 13, 23, 33 and a third region 14, 24, 34 of a semiconductor material is formed. The second and third regions are separated by a separation region. An electrically insulating layer 15, 25, 35 is formed on the first region 12, 22, 32 at least at a region corresponding to the separation region. Thereafter, a substantially conductive element 16, 26, 36 is formed on the insulating layer 15, 25, 35 at least at a region corresponding to the separation region such that the insulating layer 15, 25, 35 electrically insulates the substantially conductive element 16, 26, 36 from the first, second and third regions. The substantially conductive element 16, 26, 36 is connected to an electrode C_{B} and the second and third regions are connected to a common electrode C_{A}.

It should be noted that the present invention is not limited to the use of semiconductor materials of silicon. Other semiconductor materials, e.g. GaAs, may be used instead. Furthermore, other materials than silicon oxide, e.g. silicon nitride or a combination of silicon oxide and silicon nitride, may be used to form the insulating layer 15, 25, 35. In those cases it is more appropriate to refer to Metal-Insulator-Semiconductor, MIS, transistors instead of Metal-Oxide-Semiconductor, MOS, transistors.

Although source electrodes 17, 27, 37 drain electrodes 18, 28, 38 and gate electrodes 19, 29, 39 are included in the embodiments discussed above, it should be understood that the present invention is not limited to the use of such electrodes. Instead the source region, the drain region and the gate may be connected by other means. For example, poly-silicon may be used for achieving a suitable connection to the gate and ion-implanted regions in the well-regions 12, 22, 32 or in the substrate 11, 21, 31 may be used to connect the source region 13, 23, 33 and the drain region 14, 24, 34. A combination of different methods of connection may be used for one and the same varactor.

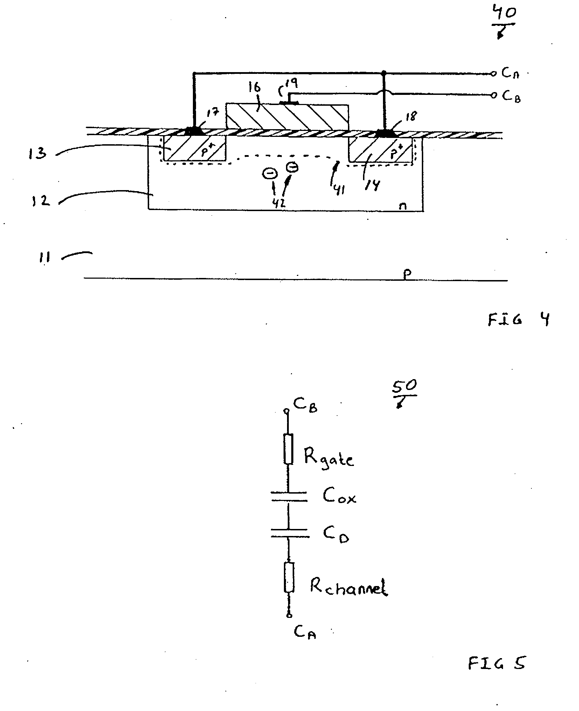

FIG 4 illustrates an operational aspect of the first example. The varactor 40 corresponds to the varactor 10 of FIG 1 and FIG 5 illustrates an equivalent circuit diagram of the varactor 40. In operation, a voltage is applied between the electrodes C_{A} and C_{B} such that the potential at C_{A} is greater than the potential at C_{B}. The surface region of the well region 12 is then depleted and the depletion width is illustrated in FIG 4 by a depletion boundary 41. The capacitance of the varactor will, inter alia, be dependent on the series combination of the oxide capacitance Cₒₓ, or corresponding capacitance if the insulating layer is not made up of an oxide, and the semiconductor depletion layer capacitance C_{D}. The depletion layer capacitance C_{D} will, in its turn, be dependent on the potential of the well and on the voltage applied over the device, *i.e.* between the source/drain and the gate. A high dynamic range of the varactor is achieved by making the well region as lightly doped as possible at the principle surface region by, for example, blocking the threshold implantation of the CMOS process. A high Q factor of the varactors is also achieved by keeping the electrical resistance of the gate R_{gate} (and its connection) and the electrical resistance R_{channel} in the well region 12 between the source region 13 and the drain region 14 as small as possible. The electrical resistance of a poly-silicon gate may be decreased by including a step for siliciding the gate. The electrical resistance experienced by the minority charge carriers 42 in the well region 12 may be reduced by using small dimensions of the gate and the channel region. Small dimensions of the gate and the channel region do, however, give rise to a varactor having a capacitance with a sometimes unacceptable small numerical value. This problem is solved by connecting a suitable number of varactors in parallel to form a composite varactor. The connections between the varactors are preferably carried out by means of a low resistance material, such as aluminium, to keep the resistance between the devices low and thereby achieving an overall high Q factor of the composite varactor.

As mentioned above, the depletion layer capacitance C_{D} is also dependent on the potential of the well and, consequently, the device may also be operated by applying fixed potentials to the electrodes C_{A} and C_{B} and controlling the capacitance of the device by a suitable voltage applied to the well. Alternatively, a fixed potential is applied to one of the electrodes C_{A} or C_{B}, the other electrode is connected to the well and the device is controlled by a suitable voltage applied to the well.

The operational aspects of the first example discussed above applies also to the second and third examples after appropriate adaptations to the applied polarities according to principles well known in the art.

Although the first, second and third examples discussed above all makes use of a p-type semiconductor substrate, n-type semiconductor substrate may be used equally well if polarities and conductivity-types are adapted according to well known principles in the art.

In a conventional 0.25µm or 0.35µm CMOS process the gate length L_{g}, corresponding substantially to the distance between the source region and the drain region, is preferably chosen to be less than 2µm and most preferably less than 1µm. The gate width W_{g} is preferably chosen to be less than 20µm, e. g. 15µm, 10µm or 5µm. In the case where a low resistance gate material, such as metal silicided poly-silicon, is used the gate width may be chosen to be less than 6µm.

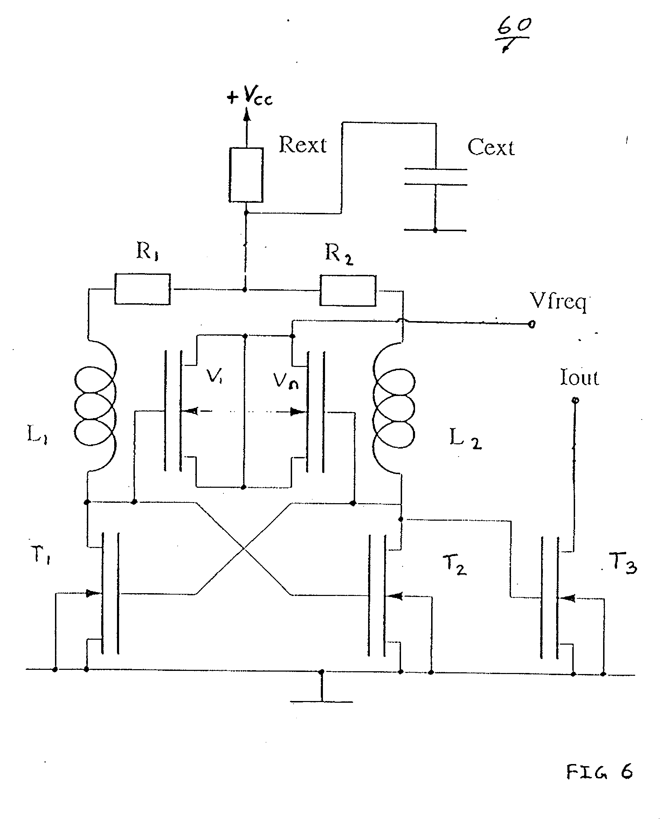

FIG 6 illustrates a circuit diagram of a Voltage Controlled Oscillator 60 according to a fourth example. The bulks and the sources of a first, a second and a third NMOS enhancement transistor, T₁, T₂, and T₃, respectively, are connected to ground potential. The gate of the first transistor T₁ is connected to the drain of the second transistor T₂ and to the gate of the third transistor T₃. The gate of the second transistor T₂ is connected to the drain of the first transistor T₁ and to a first electrode of first inductor L₁. A second electrode of the first inductor L₁ is connected to a first electrode of a first resistor R₁.

The drain of the second transistor T₂ is connected to a first electrode of a second inductor L₂. A second electrode of the second inductor is connected to a second resistor R₂. A second electrode of the first resistor R₁ is connected to a second electrode of the second resistor R₂ to a first electrode of a third resistor Rₑₓₜ and to a first electrode of a first capacitor Cₑₓₜ. A second electrode of the third resistor Rₑₓₜ is connected to a supply voltage +V_{cc} and a second electrode of the first capacitor Cₑₓₜ is connected to ground potential. The circuit further comprises at least two varactors V₁- Vₙ where n is the number of varactors. A first composite varactor is formed by coupling a predetermined number of the varactors V₁-Vₙ in parallel and a second composite varactor is formed by connecting the remaining varactors in parallel. An input connection for receiving a voltage V_{froq} which controls the frequency of the Voltage Controlled Oscillator is connected to a first electrode of each of the first and second composite varactors. A second electrode of the first composite varactor is connected to the drain of the first transistor T₁ and a second electrode of the second composite varactor is connected to the drain of the second transistor T₂. In this example, the varactors V₁-Vₙ are made up of NMOS depletion transistors. The first electrodes of the composite varactors is constituted by a common connection between the bulk and all the source regions and drain regions of the NMOS depletion transistors. The second electrode of the first composite varactor is constituted by a common connection between the gates of the NMOS depletion transistors of the first composite varactor and the second electrode of the second composite varactor is constituted by a common connection between the gates of the NMOS depletion transistors of the second composite varactor. The gates of the NMOS depletion transistors are preferably connected to the VCO circuit, and not to the input connection for receiving a voltage V_{freq}, since the gate has a low parasitic capacitance. The output signal Iₒᵤₜ of the VCO is obtained at the drain of the third transistor T₃. Optionally the third resistor Rₑₓₜ and the first capacitor Cₑₓₜ are not integrated on the chip. Furthermore, it is possible to implement the first and second inductors L₁, L₂ by making use of the inductance of bonding wires of the IC. It should be noted that the bulk of the MOS transistors making up the composite varactors V₁-Vₙ may be connected to a different potential than V_{freg}, e.g. zero potential, as long as the bulk does not form a forward biased diode with any other regions of the transistors. The operation of the VCO circuit, as such, is well known in the art.

The best performance for a given VCO circuit with given inductors is determined by the Q factor and the dynamic range (minimum and maximum capacitance value) of the (composite) varactors. According to the fourth embodiment of the present invention NMOS transistors are used. These gives the lowest parasitic resistance and thus the highest Q factor. The threshold voltage is adjusted such as to give the largest dynamic range of the (composite) varactors as is possible within a pre-determined (voltage) bias range.

In the case where the varactors of the present invention are integrated in a conventional CMOS process together with other devices the source and drain regions need to be insulated from the substrate, for example by forming the varactor in at least one well region. Although a high dynamic range of the varactors is achieved by making the well region as lightly doped as possible at the principle surface region by, for example, blocking the threshold implantation of the CMOS process, this is not always necessary and, in those cases, conventional MOS transistors may be used. It should be noted that the integration of the varactor of the present invention may also be carried out in older CMOS processes where only one well region having a conductivity type opposite to the conductivity type of the substrate is available.

Advantageously, the methods can provide an integrated Voltage Controlled Oscillator and/or Phase Locked Loop, PLL, circuit (not shown), which include a varactor as discussed above, by using a conventional CMOS process. A PLL is often used in radio communication devices (not shown), such as portable/cellular phones, for synchronising signals with reference signals possibly received by means of a radio receiver and for generating desirable frequencies in a frequency synthesiser. Since many of the functions of a radio communication device may be integrated by conventional CMOS processes, the integration of a VCO and/or a PLL circuits together with these functions allows the present invention to provide a radio communication device with a high degree of integration and thus small physical dimensions. The high degree of integration also reduces the manufacturing costs.

Two examples of (composite) varactors are presented below to illustrate that the electrical devices of the present invention may be implemented in a large number of ways without departing from the scope of the present invention.

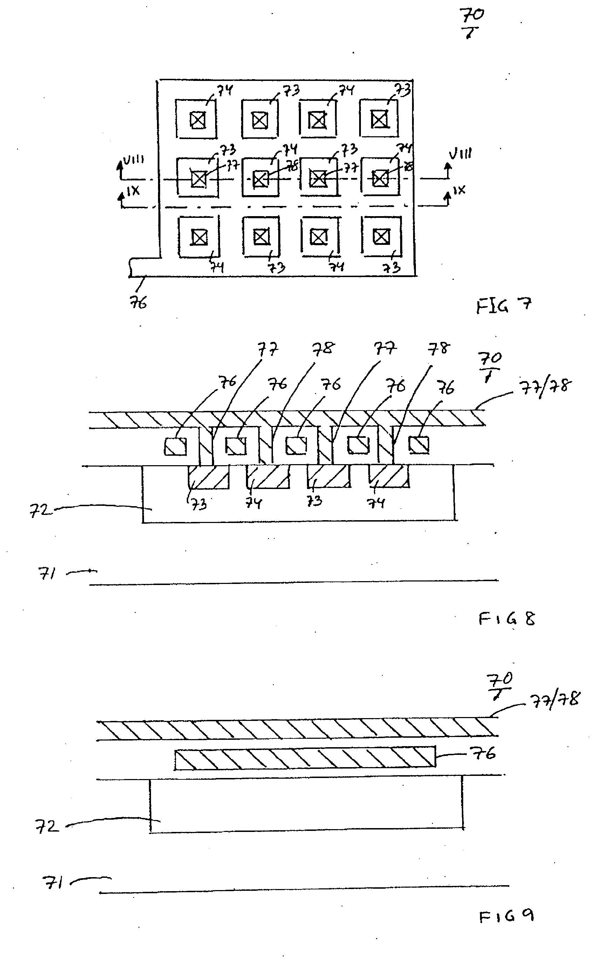

FIG 7 illustrates a top-view of a composite varactor 70 according to a fifth example of the present invention. Furthermore, FIG 8 and FIG 9 illustrate cross-section views along the axes VIII-VIII and IX-IX, respectively, of FIG 7. An n-type well region 72 is formed in a p-type substrate 71. P⁺-type regions 73, 74 are formed in the well region 72 so as to form equally spaced islands in a two-dimensional matrix. A gate 76, separated from the well and the semiconductor substrate by an insulating layer (not shown), is formed at regions corresponding to regions between the p⁺-type regions 73, 74. Preferably, but not necessarily, the gate 76 also extends such that all p⁺-type regions are surrounded by the gate. The gate 76 forms a first electrode of the composite varactor 70. All p⁺-type regions 73, 74 are connected in common by means of a second layer of poly-silicon 77/78 and connecting elements 77, 78 and forms a second electrode of the composite varactor 70. The p⁺-type regions 73, 74 make up the source regions 73 and the drain regions 74 such that the closest regions to each source region 73 are drain regions 74 and *vice versa.*

In an example of a method of manufacturing the composite varactor 70 of the fifth example the n-type well region 72 is first formed in the p-type semiconductor substrate 71. An insulating layer (not shown) is formed on the surface of the well region and a first poly-silicon layer is formed thereon. A first mask layer (not shown) is formed on the first poly-silicon layer. The first mask layer is exposed and etched to adopt a grid-shaped form (not shown). Next, the first poly-silicon layer is etched to form the gate 76. The gate 76 consequently adopts the grid-shaped form of the mask. The gate 76 forms the first electrode of the composite varactor. The remainder of the mask is removed and the p'-type source regions 73 and the p⁺-type drain regions 74 are formed by ion-implantation using the gate 76 as a mask. During this process the conductivity of the gate 76 will increase due to the ion-implantation of the gate. Alternatively, the mask is kept during the ion-implantation. Preferably, the conductivity of the gate is increased by having the gate 76 metal silicided. An insulating layer (not shown) is formed over the structure and a second mask layer (not shown) is formed thereon. The second mask layer is exposed and etched to form a mask (not shown) having openings over each of the source regions 73 and drain regions 74. Next, the insulating material in regulation with the openings will be removed in an etching step. The second mask is then removed and the second poly-silicon layer 77/78 is formed thereon. It should be noted that due to the previous etching step the second poly-silicon layer will connect to each of the source regions 73 and drain regions 74 by means of poly-silicon connecting elements 77 and 78, respectively. Thereby, the second poly-silicon layer 77/78 forms the second electrode of the composite varactor. In an alternative example poly-silicon is used to form the connecting elements 77, 78 and a metal electrode is used, instead of the poly-silicon layer 77/78, to connect the connecting elements 77, 78 in common.

The device of the fifth example can be considered as made up of a number of MOS transistors, each having a source region 73, a drain region 74, a gate 76 and a channel region formed between the source region 73 and the drain region 74, which are coupled in parallel by means of the second poly-silicon layer to form a composite varactor. The operation of each of the MOS transistors will therefore correspond to the operation of the varactors comprising a MOS transistor as discussed above.

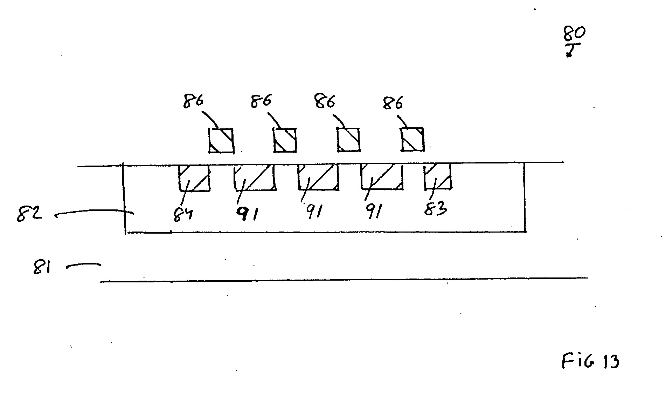

FIG 10 illustrates a top-view of a composite varactor 80 according to a sixth example made by a method according to the present invention. Furthermore, FIG 11, FIG 12 and FIG 13 illustrate cross-section views along the axes XI--XI, XII-XII and XIII-XIII, respectively, of FIG 10. An n-type well region 82 is formed in a p-type substrate 81. A p⁺-type region 83, 91, 84, 90 having a comb-shaped form is formed in the well region 82. A gate 86, separated from the substrate 81 and the well region 82 by an insulating layer (not shown), is formed at regions corresponding to the regions between the "fingers" of the comb-shaped p⁺-type region 83, 91, 84, 90. The gate 86 also extends along the edges of the "fingers" such that one common gate 86 is formed. The gate 86 forms a first electrode of the composite varactor 80 and the p⁺-type region 83, 91, 84, 90 is connected to a second electrode (not shown) of the composite varactor 80.

In the method of manufacturing according to the present invention the composite varactor 80 the n-type well region 82 is formed in the p-type semiconductor substrate 81. An insulating layer (not shown) is formed on the surface of the well region and a poly-silicon layer is formed thereon. A first mask layer (not shown) is formed on the poly-silicon layer. The first mask layer is exposed and etched to form a first mask (not shown) having a comb-shaped form. Next, the poly-silicon layer is etched to form the gate 86. The gate 86 consequently adopts the comb-shaped form of the mask. The gate 86 forms a first electrode of the composite varactor. The remainder of the mask is removed and a second mask layer (not shown) is formed on the structure. The second mask layer is exposed and etched to form a second mask (not shown) with an opening such that the "fingers" of the comb-shaped gate and an area surrounding the "fingers" are not covered by the mask. Thereafter, a p'-type source region 83, combined p⁺-type source and drain regions 91, a drain region 84 and connection regions 90 for connecting these regions are formed by ion-implantation using not only the second mask but also the gate 86 as a mask. During this process the conductivity of the gate 86 will increase due to the ion-implantation of the gate. Alternatively, the first mask is kept during the ion-implantation. Preferably, the conductivity of the gate is increase by having the gate 86 metal silicided. The ion-implanted regions 83, 91, 84 and 90 are connected and this connection forms a second electrode of the composite varactor.

The device of the sixth example can be considered as made up of a number of MOS transistors, each having a source region 91 (or 83), a drain region 91 (or 84) a gate 86 and a channel region formed between the source region and the drain region, which are coupled in parallel by means of the connection regions 90 to form a composite varactor. The operation of each of the MOS transistors will therefore correspond to the operation of the varactors comprising a MOS transistor as discussed above. In an alternative embodiment (not shown) the gate 86 is formed (at least temporary during the manufacturing) such that it also performs the function of the second mask and, hence, no second mask is needed to define the regions which are to be ion-implanted 83, 91, 84 and 90 in the steps that follow.

The composite varactors (70, 80) of the fifth and sixth examples show examples of devices having a number of varactors coupled in parallel. As discussed above, a high Q factor of each varactor can be achieved by using small dimensions of the gate and the channel region and by keeping the resistance of the gate (and its connection) as small as possible. Small dimensions of the gate and the channel region do, however, give rise to a varactor having a capacitance with a sometimes unacceptable small numerical value. A suitable capacitance of a composite varactor, e.g. the composite varactors of the fifth and sixth examples (70, 80), is therefore achieved by coupling a suitable number of varactors in parallel. Composite varactors having high Q factors and suitable capacitances are thereby provided.

An advantage of the present invention is that varactor having high quality factors, Q, i.e. with low series resistance, may be realised even for high frequency applications by using a conventional CMOS process without adding any manufacturing steps. The varactors may therefore be manufactured at high yield and to low costs.

Furthermore, an advantage of the present invention is that a VCO is provided which may be realised by using a conventional CMOS process and which does not need the addition of a DC de-coupling capacitor to the design. This makes the implementation of the VCO inexpensive and physically small since no DC de-coupling capacitor is needed neither on the IC nor externally to the IC on the PCB. These advantages becomes even more pronounced when implemented in hand-held devices, such as portable phones, which need to be small and which are produced in high-volumes.

## Claims

1. A method of manufacturing an electrical device having a voltage dependent capacitance by means of a conventional CMOS process comprising the steps of:
forming a well region (82) in a semiconductor substrate (80);
forming a first insulating layer on the surface of the well region;
forming a first poly-silicon layer on the insulating layer;
forming a first mask layer on the first poly-silicon layer;
exposing the first mask layer and etching the mask layer;
etching the poly-silicon in areas where the first mask layer has been etched to form a first electrode region (86);
removing the remainder of the first mask layer;
forming a second electrode region comprising a plurality of finger regions (83, 84, 91), separated by separation regions, the first electrode region (86) extending along edges of the finger regions (83, 84, 91), and the finger regions using the first electrode region as a mask; and the second electrode region further comprising a semiconductor region (90) connecting the finger regions (83, 84, 91).

2. A method according to claim 1, wherein the second electrode region is formed by ion-implantation.

## Patentansprüche

1. Verfahren zur Herstellung einer elektrischen Anordnung mit einer spannungsabhängigen Kapazität mithilfe eines herkömmlichen CMOS-Verfahrens, umfassend die folgende Schritte:
Bilden einer Muldenregion (82) in einem Halbleitersubstrat (80);
Bilden einer ersten Isolierschicht auf der Oberfläche der Muldenregion;
Bilden einer ersten Polysiliciumschicht auf der Isolierschicht;
Bilden einer ersten Maskenschicht auf der ersten Polysiliciumschicht;
Belichten der ersten Maskenschicht und Ätzen der Maskenschicht;
Ätzen des Polysiliciums in Bereichen, in welchen die erste Maskenschicht geätzt wurde, um eine erste Elektrodenregion (86) zu bilden;
Entfernen des Restes der ersten Maskenschicht;
Bilden einer zweiten Elektrodenregion, die eine Mehrzahl von Fingerregionen (83, 84, 91) umfasst, die durch Trennregionen getrennt sind, wobei die erste Elektrodenregion (86) entlang von Kanten der Fingerregionen (83, 84, 91) verläuft, und die Fingerregionen die erste Elektrodenregion als eine Maske verwenden; und die zweite Elektrodenregion ferner eine Halbleiterregion (90) umfasst, welche die Fingerregionen (83, 84, 91) verbindet.

2. Verfahren nach Anspruch 1, wobei die zweite Elektrodenregion durch Ionenimplantation gebildet wird.

## Revendications

1. Procédé de fabrication d'un dispositif électrique ayant une capacité variable avec la tension au moyen d'un processus CMOS conventionnel comprenant les étapes consistant à :
former une région de puits (82) dans un substrat semi-conducteur (80) ;
former une première couche isolante sur la surface de la région de puits ;
former une première couche en polysilicone sur la couche isolante ;
former une première couche de masque sur la première couche polysilicone ;
exposer la première couche de masque et graver par attaque chimique la couche de masque ;
graver par attaque chimique le polysilicone dans les zones où la première couche de masque a été gravée par attaque chimique afin de former une première région d'électrode (86) ;
retirer le restant de la première couche de masque ;
former une seconde région d'électrode comprenant une pluralité de régions de doigt (83,84,91), séparées par des régions de séparation, la première région d'électrode (86) s'étendant le long des bords des régions de doigt (83,84,91), et les régions de doigt utilisant la première région d'électrode comme masque ; et la seconde région d'électrode comprenant en outre une région de semi-conducteur (90) connectant les régions de doigt (83,84,91).

2. Procédé selon la revendication 1, dans lequel la seconde région d'électrode est formée par implantation d' ions .
